# EUROPEAN PATENT SPECIFICATION

(11) **EP 2 152 786 B1**
(45) Date of publication and mention of the grant of the patent: **17.08.2016**
(21) Application number: 08766053.6
(22) Date of filing: 02.06.2008
(51) Int. Cl.: B32B 15/04, C23C 14/34, H01L 51/52, C23C 28/00, H01L 21/314, H01L 21/316, C23C 14/06, C23C 14/54, H01L 21/318

(54) **MULTIPLE-LAYER FILM AND METHOD FOR MANUFACTURING THE SAME**
MEHRSCHICHTFOLIE UND VERFAHREN ZU DEREN HERSTELLUNG
FILM MULTICOUCHE ET PROCÉDÉ DE SA FABRICATION

(30) Priority: 01.06.2007 KR 20070053767
(43) Date of publication of application: 17.02.2010
(73) Proprietor: LG Chem, Ltd., Youngdungpo-gu, Seoul 150-721 (KR)
(72) Inventor: HWANG, Jang-Yeon, Seoul, 158-070 (KR); KIM, Dong-Ryul, Daejeon Metropolitan City, 305-721 (KR); KIM, Gi-Cheul, Daejeon Metropolitan City, 305-761 (KR); RYU, Sang-Uk, Daejeon Metropolitan City, 305-761 (KR); LEE, Ho-Jun, Daejeon Metropolitan City, 305-762 (KR); MA, Seung-Lac, Chungju-si, Chungcheongbuk-do, 380-100 (KR); KO, Myeong-Geun, Chungju-si, Chungcheongbuk-do, 360-790 (KR)
(74) Representative: Goddar, Heinz J.
(86) International application number: PCT/KR2008/003091
(87) International publication number: WO 2008/147163

(56) References cited:
- EP-A2- 1 054 456
- WO-A1-2006/082794
- JP-A- 2002 100 469
- JP-A- 2004 202 906
- JP-A- 2004 330 623
- JP-A- 2006 082 818
- JP-A- 2007 083 573
- KR-A- 20050 047 539
- KR-B1- 100 275 389
- US-A1- 2002 093 285
- US-A1- 2002 125 822
- US-A1- 2004 121 146
- US-A1- 2005 037 240
- US-A1- 2007 026 243
- US-B1- 6 277 507
- LEWIS J S ET AL: "Thin-Film Permeation-Barrier Technology for Flexible Organic Light-Emitting Devices", IEEE JOURNAL OF SELECTED TOPICS IN QUANTUM ELECTRONICS, IEEE SERVICE CENTER, PISCATAWAY, NJ, US, vol. 10, no. 1, 1 January 2004 (2004-01-01), pages 45-57, XP011111058, ISSN: 1077-260X, DOI: 10.1109/JSTQE.2004.824072
- DUGGAL A R ET AL: "A Transparent, High Barrier, and High Heat Substrate for Organic Electronics", PROCEEDINGS OF THE IEEE, IEEE. NEW YORK, US, vol. 93, no. 8, 1 August 2005 (2005-08-01) , pages 1468-1477, XP011136591, ISSN: 0018-9219, DOI: 10.1109/JPROC.2005.851483

## Description

### [Technical Field]

The present invention relates to a multiple layer film and its manufacturing method, wherein the multiple layer is excellent in its gas and moisture barrier properties and light transmittance.

### [Background Art]

Internal electronic devices, used for manufacturing an organic or inorganic light emitting device, a display device, a solar cell device or the like, have to be protected from environmental chemicals such as oxygen and moisture. Conventionally, glass plates are used as a substrate material or a cover sheet to protect the internal electronic devices which are susceptible to chemicals. The glass plates are advantageous in that they exhibit satisfactory properties including light transmittance, thermal expansion coefficient, and chemical resistance. However, since they tend to break easily, are heavy and hard, there are some limitations in terms of easiness of handling and design.

Recently, there are many studies on replacing the glass plates used as a substrate material for such electronic devices with plastic counterparts, since the plastic substrate is advantageous over the glass plate in terms of weight, impact-resistant and flexibility. Commercially available plastic films, however, show inferior properties to the glass substrate and therefore improvements in physical properties, in particular, gas barrier property, are necessary to replace it.

In order to improve gas barrier property of substrates for electronic devices, organic or inorganic materials are generally applied and deposited by various methods such as a sputtering method, a chemical vapor deposition method, and a sol-gel coating method. As the thickness of the coating layer deposited on the substrate increases, the gas barrier property can be improved but light transmittance is reduced. In addition, residual stress increases with the thickness, thereby leading to development of cracks and reduction of flexibility. In order to overcome those drawbacks, disclosed is the gas barrier structure having multiple pairs of alternating inorganic and polymer material layers (Barix^{™}), but there is a problem in that peeling off can easily occur between the deposited inorganic and polymer material layers.

Recently, in US Patent No. US 7,015,640 B2 (General Electric), disclosed is a gas barrier layer having a multiple layered structure of alternating organic and inorganic materials by controlling the ingredients of the injected raw material gas using a Plasma-enhanced chemical vapor deposition (PECVD) method, in which the composition of the coating material continuously varies from the first composition to a second composition, so as to solve the peeling-off problem between the deposited inorganic/organic material layers (Barix^{™}). However, as the volume of PECVD equipment increases, it is difficult to suitably control the composition of gaseous reactants inside the equipment in a prompt manner as desired. As a result, the composition and thickness of each layer are not easily controlled as designed. Such problems may become more serious during continuous processing such as roll-to-roll deposition process. In addition, there is a disadvantage of using hazardous materials such as silane in the PECVD process and the use of safer raw materials can cause an increase of undesired impurities in the deposited layer.

JP-A-2006082818 discloses a plastic container with an SiOC multilayer gas barrier formed thereon.
Other relevant disclosures are: US-A-6277507, EP-A-1054456, and US-A-2007026243.

### [Disclosure]

### [Technical Problem]

Accordingly, it is an object of the present invention to provide a multiple layer film which is excellent in gas and moisture barrier properties and light transmittance, and a method for manufacturing the same.

### [Technical Solution]

The present invention provides a multiple layer film in accordance with claim 1.

The present invention provides a method for manufacturing the multiple layer film in accordance with claim 14.

### [Advantageous Effects]

The multiple layer film according to the present invention is excellent in gas and moisture barrier properties and light transmittance, thereby being used as a substrate material, a protective cover, and a packaging material in electronic devices such as a light emitting device, a display device, and a solar cell device.

### [Description of Drawings]

FIG. 1 is a schematic diagram 150 illustrating deposition equipment which can be used for manufacturing the multiple layer of the present invention;
FIG. 2 is a schematic diagram 250 illustrating improved deposition equipment of FIG. 1;
FIG. 3 is a cross-sectional view 350 of a multiple layer film, manufactured by forming a multiple layer 310 on a substrate layer 320;
FIG. 4 is a cross-sectional view 450 of a multiple layer film, manufactured by attaching two multiple layer films 350 using an adhesive layer 410;
FIG. 5 is a cross-sectional view 550 of an electronic device, manufactured by forming the multiple layer 310 on an electrical circuit layer 420 which is formed on the multiple layer film 350 or 450;
FIG. 6 is a cross-sectional view 650 of an electronic device, manufactured by stacking the multiple layer film 350 or 450 on the electrical circuit layer 420 which is formed on a substrate material 430 such as glass and semiconductor wafer;
FIG. 7 is a cross-sectional view of a multiple layer according to Example 1 of the present invention;
FIG. 8 is a cross-sectional view of a multiple layer according to Example 2 of the present invention;
FIG. 9 is a cross-sectional view of a multiple layer according to Example 3 of the present invention; and
FIG. 10 is a cross-sectional view of a multiple layer according to Example 4 of the present invention.

### [Best Mode]

The multiple layer film according to the present invention comprises a substrate layer; and a multiple layer having two or more sub-layers formed by use of a single target material, provided on at least one side of the substrate layer.

The preferred substrate layer is one having excellent flexibility. In order to manufacture a multiple layer film having transparency, in accordance with the invention, a plastic film is used.

Examples of suitable materials for the plastic film used in the substrate layer are one or more selected from polyethyleneterephthalate (PET), polyarylates, polyethersulfone (PES), polycarbonates (PC), polyethylenenaphthalates (PEN), polyimide (PI), polyarylates, and an epoxy resin.

In order to improve the mechanical and thermal properties, the plastic film used in the substrate layer may form a composite resin composition with aid of the following simple fillers or fiber-type fillers.

Preferred examples of the simple fillers include metal, glass powder, diamond powder, silicon oxide, clay, calcium phosphate, magnesium phosphate, barium sulfate, aluminum fluoride, calcium silicate, magnesium silicate, barium silicate, barium carbonate, barium hydroxide, and aluminum silicate.

In addition, preferred examples of the fiber-type fillers include glass fiber and woven glass fiber.

The multiple layer consists of two or more sub-layers, and two sub-layers may be formed by use of a single target material, not multiple target materials.

In this connection, the use of a single target material means that each sub-layer is not formed by use of different targets, but formed by use of one target material, for example, one inorganic target such as silicon nitride (Si₃N₄), but is not limited thereto.

The difference in each element content between two sub-layers which is formed by use of a single target material is less than 3 at%, 0 to 1 at%, or 1 to 3 at%.

Since two or more sub-layers are formed by use of the single target material, the manufacturing process can be simplified. In addition, there is little difference (3 at% or less) in element content between the sub-layers, thereby reducing peeling off which easily occurs between the multiple layer films.

Accordingly, provided is a multiple layer film which is excellent in gas and moisture barrier properties and light transmittance.

The single target material used for the multiple layer may include one or more layer-constituting materials selected from Si, Al, Sn, Ti, Ni, W, oxide thereof, nitride thereof, and carbide thereof.

The element composition of each sub-layer may include silicon (Si), oxygen (O) and nitrogen (N), and further include carbon (C).

The element composition of each sub-layer may include silicon (Si) and nitrogen (N), and the element ratio (Si/N) of silicon (Si) to nitrogen (N) may be 1 to 20. In addition, the element ratio (Si/N) of silicon (Si) to nitrogen (N) may be 1.7 to 15.

The element composition of each sub-layer may include oxygen (0) and nitrogen (N), and the element ratio (O/N) of oxygen (O) to nitrogen (N) may be 0.1 to 30. In addition, the element ratio (O/N) of oxygen (O) to nitrogen (N) may be 1.4 to 26.

The element composition of each sub-layer may include oxygen (O) and silicon (Si), and the element ratio (O/Si) of oxygen (O) to silicon (Si) may be 0.1 to 2. In addition, the element ratio (O/Si) of oxygen (0) to silicon (Si) may be 0.8 to 1.7.

The element composition of each sub-layer may include silicon (Si), nitrogen (N) and oxygen (O), and the element ratio (Si/N) of silicon (Si) to nitrogen (N) may be 1 to 20, and the element ratio (O/N) of oxygen (O) to nitrogen (N) may be 0.1 to 30.

The element composition of each sub-layer may include silicon (Si), nitrogen (N) and oxygen (O), and the element ratio (Si/N) of silicon (Si) to nitrogen (N) may be 1.7 to 15, and the element ratio (O/N) of oxygen (O) to nitrogen (N) may be 1.4 to 26.

The element composition of each sub-layer may include silicon (Si), nitrogen (N) and oxygen (0), and the element ratio (Si/N) of silicon (Si) to nitrogen (N) may be 1 to 20, the element ratio (O/N) of oxygen (O) to nitrogen (N) may be 0.1 to 30, and the element ratio (O/Si) of oxygen (O) to silicon (Si) may be 0.1 to 2.

The element composition of each sub-layer may include silicon (Si), nitrogen (N) and oxygen (O), and the element ratio (Si/N) of silicon (Si) to nitrogen (N) may be 1.7 to 15, the element ratio (O/N) of oxygen (O) to nitrogen (N) may be 1.4 to 26, and the element ratio (O/Si) of oxygen (0) to silicon (Si) may be 0.8 to 1.7.

The element composition of each sub-layer may include 30 to 50 at% of silicon (Si), 10 to 65 at% of oxygen (0), and 1 to 50 at% of nitrogen (N), based on the total content of elements constituting each sub-layer.

The element composition of each sub-layer may include 30 to 50 at% of silicon (Si), 10 to 65 at% of oxygen (0), 1 to 50 at% of nitrogen (N), and more than 0 to 5 at% of carbon (C), based on the total content of elements constituting each sub-layer.

Each sub-layer may have an element ratio of 0.5 to 1 for oxygen (0) and nitrogen (N) to silicon (Si) that are represented by the following Formula 1.

(Formula 1) (O₂+N_{4/3})/Si

Each sub-layer may have a thickness of 0.1 nm to 50 nm, preferably 0.5 nm to 30 nm, and more preferably 0.5 nm to 15 nm.

Two sub-layers have a different thickness from each other.

Among the two sub-layers, one sub-layer has a thickness of 0.1 to 50 nm, and the other sub-layer has a thickness of 0.1 to 10 nm.

In addition, among two or more sub-layers, two sub-layers having a different thickness may be repeatedly stacked in turn.

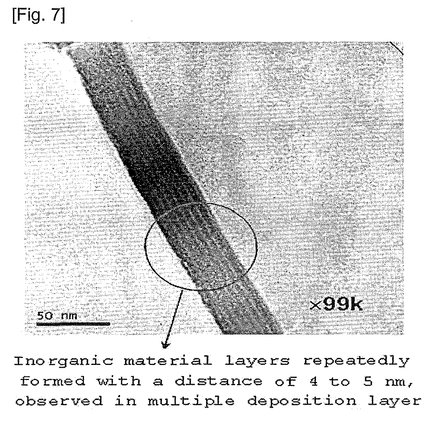

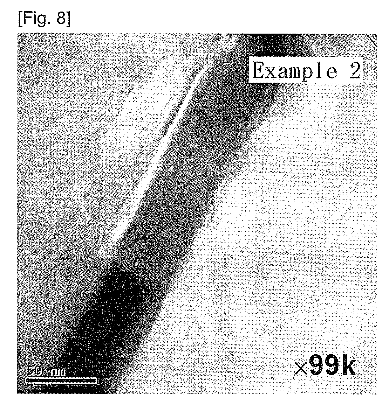

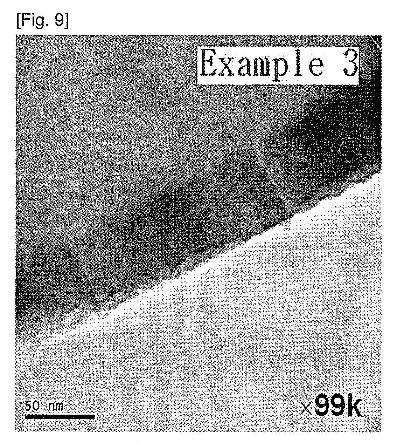

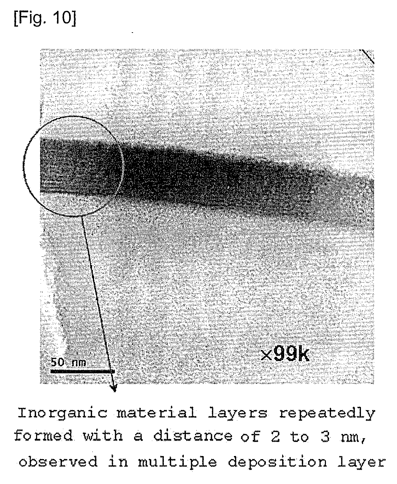

For example, as shown in FIGs. 7 to 10, a multiple layer having two or more sub-layers may have a multi-layered structure of alternately stacking a first sub-layer in a thickness range of 0.1 to 50 nm, a second sub-layer being thinner than the first sub-layer in a thickness range of 0.1 to 10 nm, the first sub-layer in a thickness range of 0.1 to 50 nm, and the second sub-layer being thinner than the first sub-layer in a thickness range of 0.1 to 10 nm.

The thickness of the multiple layer having two or more sub-layers may be preferably determined depending on the thickness of each sub-layer and stacking number, preferably in a range of 10 nm to 5000 nm, more preferably in a range of 10 nm to 1000 nm, and most preferably in a range of 10 nm to 300 nm.

The multiple layer having two or more sub-layers may be formed on one side or both sides of the substrate layer, and two or more multiple layer films comprising the multiple layer according to the present invention may be attached to each other, and then used.

Furthermore, the multiple layer film according to the present invent ion may further include a coating layer which is provided on at least one side of the multiple layer.

The coating layer may improve the physical properties of the substrate layer, or provide new properties such as enhancement in attachment between the substrate layer and multiple layer, relaxation of stress which is applied to the multiple layer upon mechanical deformation of the multiple layer film, and prevention of handling damage.

The coating layer may be formed by singly or in combination of one or more materials selected from sol-gel materials, acrylic series, epoxy series, and urethane series using a thermal curing and/or photo curing method.

Furthermore, another type of the multiple layer film of the present invention comprises a substrate layer; and a multiple layer provided on at least one side of the substrate layer, in which the multiple layer has a structure of stacking two or more sub-layers formed by use of one or more layer-constituting materials selected from Si, Al, Sn, Ti, Ni, W, oxide thereof, nitride thereof, and carbide thereof, and difference in element content between two sub-layers is 3 at% or less. A detailed description thereof, which is the same as the above mentioned, will be omitted.

The multiple layer film according to the present invention is excellent in gas and moisture barrier properties and light transmittance, thereby being manufactured as a substrate material having an electrical insulating property depending on the materials which are deposited on the substrate layer, for example, as a substrate material in electrophoretic display (EPD), organic light emitting diode (OLED), inorganic light emitting device, or the like.

In addition, the multiple layer film according to the present invention can be used for the purpose of protecting internal electronic devices susceptible to environmental gas such as moisture and oxygen, for example, EPD, OLED, inorganic light emitting device or packaging the products which requires a gas-barrier.

A method for manufacturing the multiple layer film according to the present invention may comprise the step of forming two sub-layers by use of a single target material in order to form the multiple layer having two or more sub-layers on at least one side of the substrate layer. A detailed description thereof, which is the same as the above mentioned, will be omitted.

In the step of forming two or more sub-layers, if the multiple layer is not formed by use of multiple target materials, but formed by use of a single target material by a single process, the manufacturing process can be simplified. In addition, there is little difference in element content between the sub-layers (3 at% or less), thereby providing a multiple layer film which is excellent in gas and moisture barrier properties and light transmittance.

In the case of using multiple target materials in the same deposition chamber under the different conditions, the target materials or process gas may be easily mutually contaminated. In the present invention, the single target material is used for a single process. Thus, in consideration of the productivity, even if the single target material is repeatedly used, there is no risk of causing cross-contamination due to a difference in conditions of the target material and process gas.

In addition, in the case of forming the sub-layers using the single target material, since the sub-layers which may be observed under an electron microscope have differences in the element composition or crystal structure, the initialization of deposition can be expected each time by the repeated deposition of the sub-layers. That is, the suppression of defect growth or propagation, due to the repeated stacking of organic and inorganic material layers, between the layers can be provided by the micro multi-layered structure in the present invention, thereby obtaining the excellent gas barrier property.

Specifically, when two or more sub-layers are repeatedly stacked, a difference in the element composition (3 at% or less) or micro-crystal structure occurs in the interface to form a layered structure which can be observed under an electron microscope.

The sub-layers between two adjacent layers are regularly stacked, which functions to initialize each deposition. Thus, during the deposition using the single target material, defect propagation can be prevented so as to improve the gas barrier property. Accordingly, in the present invention, the micro multi-layered structure is repeatedly formed to provide a multiple layer having two sub-layers.

Two or more sub-layers can be deposited using silicon nitride (Si₃N₄) as the single target material in a mixed reactive gas atmosphere of nitrogen and oxygen.

The mixed reactive gas of nitrogen and oxygen may be used in a ratio of more than 0 and 60% or less, based on the total process gas.

The ratio of oxygen and nitrogen contained in the mixed reactive gas may be 1:100 to 80:30. In the consideration of light transmittance, the ratio of oxygen and nitrogen contained in the mixed reactive gas may be 30:70 to 75:25.

The step of forming two or more sub-layers may be performed under a pressure of 0.5 to 20 mTorr.

According to the method of manufacturing the multiple layer film of the present invention, at least one of processing conditions such as gas flow rate, processing pressure and deposition rate can be adjusted depending on deposition conditions of the sub-layers, so as to change the micro multi-layered structure, and control the element composition within the predetermined range.

The sub-layer is preferably deposited by a sputtering method, an ion plating method, a chemical deposition method, and a sol-gel coating method. However, to effectively achieve the object of the present invention, a sputtering method or ion plating method may be preferably used.

In this connection, the process parameters of the sputtering method are adjusted to control the micro structure, element composition, or thickness of each sub-layer which constitutes the multiple layer.

In the case of depositing several layers by a sputtering method, target materials corresponding to the number of deposited layers are generally used. However, in the case of using the single target material, the composition of deposited layers can be changed by controlling the composition of feeding reactive gas. For example, in the case of using metals such as Si, Al, Sn, Ti, Ni, and Wets., various inorganic material layers are formed and deposited by controlling the type (e.g., oxygen, nitrogen) or concentration of reactive gas used in the sputtering process. In addition, in the case of using carbide or nitride as the target, the process gas is mixed with other reactive gas (e.g., oxygen, ammonia) to adjust the relative reactivity with the target materials, and thus the composition of the deposited sub-layer can be easily controlled.

In the sputtering method according to the present invention, in addition to the composition of the process gas, other process factors such as process pressure, feeding energy to the target, cooling conditions for the deposited inorganic materials during deposition process, geometry of deposition equipment, and deposition time are adjusted to control the constitution of the multiple layer having the sub-layers. It is because that the process factors are adjusted, thereby changing the element composition or micro structure of each sub-layer. Therefore, even though using the single target material and controlling the process factors into a single condition, it is possible to form the multiple layer which consists of various sub-layers having various micro-inorganic material structures and element compositions.

Preferred examples of the process gas used in the sputtering method according to the present invention include a mixed reactive gas of two or more selected from argon, helium, nitrogen (or ammonia), oxygen, nitrogen trifluoride (NF₃), and methane trifluoride (CHF₃).

In this connection, argon or helium is preferably used as a basic process gas, and at least others used as a reactive process gas together with the basic process gas. The total amount of gas feed is adjusted within a range capable of maintaining the sputtering pressure of 0.5 to 20 mTorr. The reactive gas mixed in the process gas may be used in a content of more than 0 and 60% or less, based on the total process gas, in order to change the element composition of inorganic material to be deposited. For example, the pressure may be maintained in the range of 0.5 to 20 mTorr, and the content of a reactive gas mixture may be in the range of more than 0 and 35% or less, but is not limited thereto.

Using two or more of the reactive gas, for example, both oxygen and nitrogen, within the above range, the element composition of inorganic material to be deposited can be controlled.

In the sputtering process, the thickness of each sub-layer constituting the multiple layer varies depending on feeding energy, gas composition, moving speed of deposition substrate material, and process pressure, and these factors can be adjusted depending on a deposition system to achieve optimum physical properties (gas barrier property, light transmittance, etc).

In the sputtering process, the element composition of each sub-layer constituting the multiple layer may vary depending on the type of target material, the type and concentration of reactive gas, process pressure, and feeding energy to the target.

In the sputtering process, the micro structure of each sub-layer constituting the multiple layer may vary depending on the feeding energy, and cooling conditions for deposited layers during deposition process as well as element composition in the layer. In particular, with respect to the cooling conditions, the deposition system can be equipped with an additional cooling mechanism in order to easily control the cooling of deposited layer after or during the deposition process.

The sputter may preferably control the major process factors such as the feeding energy to the target, moving speed of substrate material (or cooling rate of substrate material), process pressure, and flow rate and composition of process gas.

Herein below, the method of manufacturing the multiple layer film according to the present invention will be described in detail with reference to drawings.

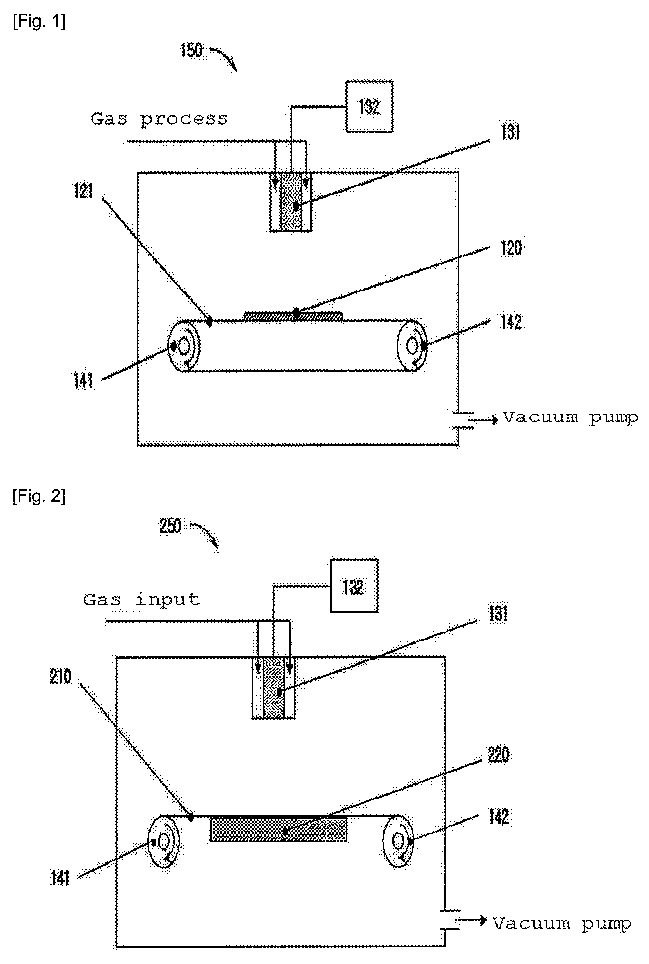

FIG.1 is a schematic diagram of a deposition system 150, which can be used for manufacturing the multiple layer according to the present invention by a sputtering method. In the deposition equipment 150, the target 131 is fixed above the substrate material 120, and electric power is supplied thereto by a power supply 132. The substrate material 120 is placed on a conveyor belt 121, and moves right and left by rotation of a pair of rollers 141 and 142. The rotation speed of the rollers 141 and 142 is controllable in a right and left direction, the moving distance of the substrate material is variable in a right and left direction under the target, and the stay time of the substrate material 120 on both ends of conveyor belt 121 is arbitrarily controllable.

FIG. 2 is a schematic diagram of an improved deposition equipment 250, manufactured by improving the equipment 150 of FIG. 1 for a continuous process of films by means of the rollers 141 and 142, in which the improved system is equipped with a cool ing mechanism 220 under the moving substrate material to control the cooling conditions for deposited layers during or after deposition process. In addition, in the case of using the deposition system (150 or 250) equipped with two or more targets, it is possible to form the multiple layer having a variety of micro multi-layered structures.

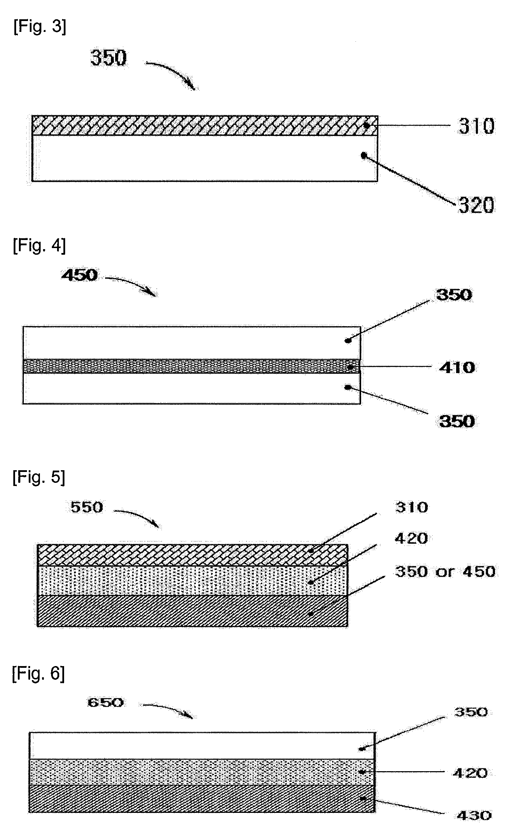

FIG. 3 shows a cross-section of a multiple layer film 350, manufactured by forming the multiple layer 310 consisting of several sub-layers on the substrate layer 320.

FIG. 4 shows a cross-section of a multiple layer film 450, manufactured by attaching two multiple layer films 350 using an adhesive layer 410.

FIG. 5 shows a cross-section of an electronic device 550, manufactured by forming the multiple layer 310 on an electrical circuit layer 420 which is formed on the multiple layer film 350 or 450.

FIG. 6 shows a cross-section of an electronic device 650, manufactured by stacking the multiple layer film 350 or 450 on the electrical circuit layer 420 which is formed on a substrate material 430 such as glass and semiconductor wafer.

The present invention provides a light emitting device, a display device, or a solar cell device, comprising the multiple layer film.

### [Mode for Invention]

Hereinafter, the present invention will be described in detail in light of Examples. The present invention may, however, be embodied in many different forms and should not be construed as being limited to the Examples set forth herein. Rather, these Examples are provided such that this disclosure will be thorough and complete and will fully convey the concept of the present invention as set out in the claims to those skilled in the art.

### <Examples 1 to 4>

A multiple layer was deposited on a PET substrate layer having a thickness of 100 µm by sputtering a single silicon nitride (Si₃N₄). Examples 1 to 4 were performed by varying the composition of the process gas and the process pressure, as shown in Table 1, and the composition of the process gas was maintained in the ratio shown in Table 1, during the deposition process in each example. The common process conditions are as follows: The 2 kW of electric energy was fed to the target, the concentration of mixed reactive gas of oxygen and nitrogen was maintained in 20%, based on the total process gas, and the moving distance of the substrate material was adjusted in each direction under the target.

### <Comparative Examples 1 and 2>

In Comparative Example 1, a substrate layer having no multiple layer was deposited, and in Comparative Example 2, a multiple layer film was manufactured by sputtering SiO₂ target under the conditions of maintaining the oxygen concentration of 10%, based on the total process gas, and the feeding energy of 2 kW.

### <Experimental Example 1> Measurement of moisture permeability and light transmittance

In order to evaluate properties of the multiple layers of the present invention, the moisture permeability and light transmittance of each multiple layer film were measured. The moisture permeability was measured with a water vapor permeability tester (L80-5000, Lyssy) at 38°C under maintaining the humidity difference of 90 %RH on both sides of the film, and the light transmittance was measured with a spectrophotometer (Cary 3E, Varian). The cross-section of the multiple layer was analyzed using a transmission electron microscope (TEM, TECHNAI 20-S, Philips). The measured results are shown in the following Table 1.

**[Table 1]**

| | Input oxygen: nitrogen | Pressure (mTorr) | moisture permeability (g/m² · day) | light transmittance (%, 550 nm) | thickness of multiple layer(nm) |
|---|---|---|---|---|---|
| Comparative Example 1 | - | - | 3.7 | 92 | - |
| Comparative Example 2 | - | 2.0 | 0.09 | 91 | 55 |
| Example 1 | 0 : 100 | 2.0 | < 0.03 | 82 | 38 |
| Example 2 | 30 : 70 | | < 0.03 | 85 | 45 |
| Example 3 | 70 : 30 | | < 0.03 | 90 | 50 |
| Example 4 | 30 : 70 | 4.0 | 0.034 | 88 | 45 |

As shown in Table 1, the multiple layer films manufactured in Examples 1 to 3 were found to have the moisture permeability under the detection limit of the tester, and to maintain the excellent light transmittance depending on sputtering conditions. FIGs. 7 to 10 show the cross-sections of the multiple layers deposited in Examples 1 to 4, observed using the transmission electron microscope (TEM), in which the multiple layer is formed by repeatedly stacking thin constitution layers having a thickness of about 2 to 5 nm, even though a single target and a single gas condition were used in each case.

### <Experimental Example 2> Elemental analysis and measurement of water contact angle of multiple layers

The elemental analysis of the multiple layers according to Examples 1 to 4 was performed using an XPS (X-ray Photoelectron Spectroscopy, ESCA Lab 250 System), and the results are shown in Tables 2 to 4. To evaluate surface characteristic of the multiple layers according to Examples 1 to 4, the water droplet contact angle was measured, and the results are shown in Table 2.

**[Table 2]**

| Example | Input oxygen: nitrogen | Element content (at%) | | | | element ratio | | | | droplet contact angle |
|---|---|---|---|---|---|---|---|---|---|---|
| | | Si | O | N | C | Si/N | O/N | O/Si | (O₂+N_{4/3})/Si | |
| 1 | 0 : 100 | 45 | 14 | 39 | 2 | 1.1 | 0.4 | 0.31 | 0.80 | 41.7° |
| 2 | 30 : 70 | 41 | 33 | 24 | 2 | 1.7 | 1.4 | 0.80 | 0.84 | 38.6° |
| 3 | 70 : 30 | 36 | 61 | 3 | 0 | 12 | 24 | 1.69 | 0.91 | 23.2° |
| 4 | 30 : 70 | 40 | 40 | 20 | 0 | 2.0 | 2.0 | 1.00 | 0.88 | 37.1° |

**[Table 3]**

| Atom% | Example 1 | | | | Example 2 | | | |
|---|---|---|---|---|---|---|---|---|
| | 0sec | 10sec | 30sec | 80sec | 0sec | 10sec | 30sec | 80sec |
| O | 26.5 | 20.8 | 15.6 | 14.1 | 38.4 | 37.0 | 35.0 | 33.4 |
| N | 30.1 | 34.7 | 37.4 | 39.5 | 19.9 | 21.4 | 22.9 | 24.1 |
| Si | 35.5 | 42.3 | 44.7 | 45.1 | 34.7 | 39.5 | 41.1 | 41.3 |
| C | 7.9 | 2.3 | 2.3 | 1.3 | 7.0 | 2.1 | 1.1 | 1.1 |

**[Table 4]**

| Atom% | Example 3 | | | | Example 4 | | | |
|---|---|---|---|---|---|---|---|---|
| | 0sec | 10sec | 30sec | 80sec | 0sec | 10sec | 30sec | 80sec |
| 0 | 59.4 | 61.0 | 61.3 | 61.3 | 43.5 | 43.0 | 41.2 | 40.0 |
| N | 4.5 | 3.5 | 2.5 | 2.7 | 18.1 | 18.9 | 19.7 | 20.0 |
| Si | 29.9 | 35.6 | 36.2 | 35.9 | 31.6 | 35.9 | 38.5 | 40.0 |
| C | 6.2 | - | - | - | 6.8 | 2.3 | 0.6 | 0.1 |

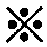 Tables 3 and 4 are the results of XPS elemental analysis, performed by repeating Ar ion etching to remove impurities upon exposure to atmosphere, in which a time point (sec) indicates a time period spent for Ar ion etching under predetermined conditions, and elemental analysis was performed at each time point.

As shown in the water droplet contact angle in Table 2, the surface characteristic of multiple layer can be controlled by varying the process conditions.

In addition, as shown in Table 2, the sub-layers constituting the multiple layers of Examples 1 to 4 according to the present invention were found to have the element composition of Si, 0, N or 0, N, Si, C, indicating that the element composition of the multiple layer can be controlled by adjusting the process conditions.

As shown in Tables 3 to 4 which are the results of analyzing the element composition at each time point, when two or more sub-layers constituting the multiple layers of Examples 1 to 4 were formed by using a single target material, the differences in element compositions between the sub-layers were maintained within the error range, upon etching for 10 seconds or more.

Accordingly, when the multiple layer having two or more sub-layers is not formed by use of multiple target materials, but formed by use of a single target material and a single set of process conditions, there is little difference (3 at% or less) in element content between two or more sub-layers formed by use of the single target material, thereby providing the multiple layer film which is excellent in gas and moisture barrier properties and light transmittance.

## Claims

1. A multiple layer film, comprising
a substrate layer; and
a multiple layer provided on at least one side of the substrate layer,
wherein the substrate layer is a plastic film,
wherein the multiple layer has a multi-layered structure, in which sub-layers formed from one or more layer-constituting materials selected from Si, Al, Sn, Ti, Ni, W, oxide thereof, nitride thereof and carbide thereof are repeatedly
stacked,
wherein a difference in each element content between the sub-layers is 3 at% or less,
wherein one sub-layer is directly stacked on another sub-layer being contacted with each other, and
wherein the multi-layered structure has a structure, in which a first sub-layer in a thickness range from 0.1 nm to 50 nm, a second sub-layer being thinner than the first sub-layer in a thickness range from 0.1 nm to 10 nm, the first sub-layer in the thickness range from 0.1 to 50 nm and the second sub-layer being thinner than the first sub-layer in the thickness range from 0.1 nm to 10 nm are alternately stacked.

2. The multiple layer film according to claim 1, wherein the element composition of each sub-layer comprises silicon (Si) and nitrogen (N), and the element ratio (Si/N) of silicon (Si) to nitrogen (N) is 1 to 20.

3. The multiple layer film according to claim 1, wherein the element composition of each sub-layer comprises oxygen (O) and nitrogen (N), and the element ratio (O/N) of oxygen (O) to nitrogen (N) is 0.1 to 30.

4. The multiple layer film according to claim 1, wherein the element composition of each sub-layer comprises oxygen (O) and silicon (Si), and the element ratio (O/Si) of oxygen (O) to silicon (Si) is 0.1 to 2.

5. The multiple layer film according to claim 1, wherein the element composition of each sub-layer comprises silicon (Si), nitrogen (N) and oxygen (O), the element ratio (Si/N) of silicon (Si) to nitrogen (N) is 1 to 20, and the element ratio (O/N) of oxygen (O) to nitrogen (N) is 0.1 to 30.

6. The multiple layer film according to claim 1, wherein the element composition of each sub-layer comprises silicon (Si), nitrogen (N) and oxygen (O), the element ratio (Si/N) of silicon (Si) to nitrogen (N) is 1 to 20, the element ratio (O/N) of oxygen (O) to nitrogen (N) is 0.1 to 30, and the element ratio (O/Si) of oxygen (O) to silicon (Si) is 0.1 to 2.

7. The multiple layer film according to claim 1, wherein the element composition of each sub-layer comprises 30 to 50 at% of silicon (Si), 10 to 65 at% of oxygen (O), and 1 to 50 at% of nitrogen (N), based on the total content of elements constituting each sub-layer.

8. The multiple layer film according to claim 1, wherein the element composition of each sub-layer comprises 30 to 50 at% of silicon (Si), 10 to 65 at% of oxygen (O), 1 to 50 at% of nitrogen (N), and more than 0 to 5 at% of carbon (C), based on the total content of elements constituting each sub-layer.

9. The multiple layer film according to claim 1, wherein each sub-layer has an element ratio ((O₂ +N_{4/3})/Si) of oxygen (O) and nitrogen (N) with respect to silicon (Si) ranging from 0.5 to 1.

10. The multiple layer film according to claim 1, wherein the multiple layer has a thickness of 10 to 5000 nm.

11. The multiple layer film according to claim 1, further comprising a coating layer provided on at least one side of the multiple layer.

12. A display device comprising the multiple layer film according to claim 1.

13. A solar cell device comprising the multiple layer film according to claim 1.

14. A method for manufacturing the multiple layer film according to any one of claims 1 to 11, comprising forming the sub-layers by use of a single target material in order to form the multiple layer having the sub-layers on at least one side of the substrate layer, wherein the difference in each element content between the sub-layers is 3 at% or less, wherein the substrate layer is the plastic film and wherein the multiple layer comprises a multi-layered structure, in which a first sub-layer in a thickness range from 0.1 nm to 50 nm, a second sub-layer being thinner than the first sub-layer in a thickness range from 0.1 nm to 10 nm, the first sub-layer in the thickness range from 0.1 to 50 nm and the second sub-layer being thinner than the first sub-layer in the thickness range from 0.1 nm to 10 nm are alternately stacked.

15. The method for manufacturing the multiple layer film according to claim 14, wherein the sub-layers are deposited using silicon nitride (Si₃N₄) as the single target material under a mixed reactive gas of nitrogen and oxygen.

16. The method for manufacturing the multiple layer film according to claim 15, wherein the mixed reactive gas of nitrogen and oxygen is used in a ratio of more than 0 and 60% or less, based on the total process gas.

17. The method for manufacturing the multiple layer film according to claim 15, wherein the ratio of oxygen and nitrogen contained in the mixed reactive gas of nitrogen and oxygen is 1:100 to 80:30.

18. The method for manufacturing the multiple layer film according to claim 14, wherein the step of forming the sub-layers is performed under the pressure of 0.5 to 20 mTorr.

19. The method for manufacturing the multiple layer film according to claim 14, further comprising the step of forming a coating layer on at least one side of the multiple layer.

20. The method for manufacturing the multiple layer film according to claim 14, wherein the single target material comprises one or more selected from Si, Al, Sn, Ti, Ni, W, oxide thereof, nitride thereof, and carbide thereof.

## Patentansprüche

1. Mehrschichtige Folie, umfassend:
eine Substratschicht; und
eine Mehrfachschicht, die auf wenigstens einer Seite der Substratschicht bereitgestellt ist,
wobei die Substratschicht eine Kunststofffolie ist,
wobei die Mehrfachschicht eine mehrschichtige Struktur aufweist, bei der Unterschichten, gebildet aus einem oder mehreren Schicht-bildenden Materialien ausgewählt aus Si, Al, Sn, Ti, Ni, W, Oxid derselben, Nitrid derselben und Carbid derselben, wiederholt gestapelt sind,
wobei ein Unterschied in jedem Elementgehalt zwischen den Unterschichten 3 at% oder weniger ist,
wobei eine Unterschicht direkt auf einer anderen Unterschicht, die in Kontakt miteinander sind, gestapelt ist, und
wobei die mehrschichtige Struktur eine Struktur mit einer ersten Unterschicht in einem Dickenbereich von 0,1 nm bis 50 nm und einer zweiten Unterschicht, die dünner ist als die erste Unterschicht, in einem Dickenbereich von 0,1 nm bis 10 nm aufweist, wobei die erste Unterschicht in dem Dickenbereich von 0,1 bis 50 nm und die zweite Unterschicht, die dünner ist als die erste Unterschicht, in dem Dickenbereich von 0,1 nm bis 10 nm alternierend gestapelt sind.

2. Mehrschichtige Folie nach Anspruch 1, wobei die Elementzusammensetzung jeder Unterschicht Silicium (Si) und Stickstoff (N) umfasst und das Elementverhältnis (Si/N) von Silicium (Si) zu Stickstoff (N) 1 bis 20 ist.

3. Mehrschichtige Folie nach Anspruch 1, wobei die Elementzusammensetzung jeder Unterschicht Sauerstoff (O) und Stickstoff (N) umfasst und das Elementverhältnis (O/N) von Sauerstoff (O) zu Stickstoff (N) 0,1 bis 30 ist.

4. Mehrschichtige Folie nach Anspruch 1, wobei die Elementzusammensetzung jeder Unterschicht Sauerstoff (O) und Silicium (Si) umfasst und das Elementverhältnis (O/Si) von Sauerstoff (O) zu Silicium (Si) 0,1 bis 2 ist.

5. Mehrschichtige Folie nach Anspruch 1, wobei die Elementzusammensetzung jeder Unterschicht Silicium (Si), Stickstoff (N) und Sauerstoff (O) umfasst und das Elementverhältnis (Si/N) von Silicium (Si) zu Stickstoff (N) 1 bis 20 ist und das Elementverhältnis (O/N) von Sauerstoff (O) zu Stickstoff (N) 0,1 bis 30 ist.

6. Mehrschichtige Folie nach Anspruch 1, wobei die Elementzusammensetzung jeder Unterschicht Silicium (Si), Stickstoff (N) und Sauerstoff (O) umfasst, das Elementverhältnis (Si/N) von Silicium (Si) zu Stickstoff (N) 1 bis 20 ist, das Elementverhältnis (O/N) von Sauerstoff (O) zu Stickstoff (N) 0,1 bis 30 ist und das Elementverhältnis (O/Si) von Sauerstoff (O) zu Silicium (Si) 0,1 bis 2 ist.

7. Mehrschichtige Folie nach Anspruch 1, wobei die Elementzusammensetzung jeder Unterschicht 30 bis 50 at% Silicium (Si), 10 bis 65 at% Sauerstoff (O) und 1 bis 50 at% Stickstoff (N) umfasst, basierend auf dem Gesamtgehalt der Elemente, die jede Unterschicht ausbilden.

8. Mehrschichtige Folie nach Anspruch 1, wobei die Elementzusammensetzung jeder Unterschicht 30 bis 50 at% Silicium (Si), 10 bis 65 at% Sauerstoff (O), 1 bis 50 at% Stickstoff (N) und mehr als 0 bis 5 at% Kohlenstoff (C) umfasst, basierend auf dem Gesamtgehalt der Elemente, die jede Unterschicht ausbilden.

9. Mehrschichtige Folie nach Anspruch 1, wobei jede Unterschicht ein Elementverhältnis ((O₂+N_{4/3})/Si) von Sauerstoff (O) und Stickstoff (N) in Bezug auf Silicium (Si) in einem Bereich von 0,5 bis 1 aufweist.

10. Mehrschichtige Folie nach Anspruch 1, wobei die Mehrfachschicht eine Dicke von 10 bis 5.000 nm aufweist.

11. Mehrschichtige Folie nach Anspruch 1, weiter umfassend eine Beschichtungsschicht, die auf wenigstens einer Seite der Mehrfachschicht bereitgestellt ist.

12. Displayvorrichtung umfassend die mehrschichtige Folie nach Anspruch 1.

13. Solarzellenvorrichtung umfassend die mehrschichtige Folie nach Anspruch 1.

14. Verfahren zum Herstellen der mehrschichtigen Folie nach einem der Ansprüche 1 bis 11, umfassend Ausbilden der Unterschichten durch Verwendung eines einzelnen Zielmaterials, um die Mehrfachschicht mit den Unterschichten auf wenigstens einer Seite der Substratschicht zu bilden, wobei der Unterschied in jedem Elementgehalt zwischen den Unterschichten 3 at% oder weniger ist, wobei die Substratschicht die Kunststofffolie ist, und wobei die Mehrfachschicht eine mehrschichtige Struktur mit einer ersten Unterschicht in einem Dickenbereich von 0,1 nm bis 50 nm und einer zweiten Unterschicht, die dünner ist als die erste Unterschicht, in einem Dickenbereich von 0,1 nm bis 10 nm aufweist, wobei die erste Unterschicht in dem Dickenbereich von 0,1 bis 50 nm und die zweite Unterschicht, die dünner ist als die erste Unterschicht, in dem Dickenbereich von 0,1 nm bis 10 nm alternierend gestapelt werden.

15. Verfahren zum Herstellen der mehrschichtigen Folie nach Anspruch 14, wobei die Unterschichten unter Verwendung von Siliciumnitrid (Si)N₄) als das einzelne Zielmaterial unter einem gemischten Reaktivgas aus Stickstoff und Sauerstoff abgeschieden werden.

16. Verfahren zum Herstellen der mehrschichtigen Folie nach Anspruch 15, wobei das gemischte Reaktivgas aus Stickstoff und Sauerstoff verwendet wird in einem Verhältnis von mehr als 0 und 60% oder weniger, basierend auf dem gesamten Prozessgas.

17. Verfahren zum Herstellen der mehrschichtigen Folie nach Anspruch 15, wobei das Verhältnis von Sauerstoff und Stickstoff, die in dem gemischten Reaktivgas aus Stickstoff und Sauerstoff enthalten sind, 1:100 bis 80:30 ist.

18. Verfahren zum Herstellen der mehrschichtigen Folie nach Anspruch 14, wobei der Schritt des Bildens der Unterschichten unter dern Druck von 0,5 bis 20 mTorr durchgerührt wird.

19. Verfahren zum Herstellen der mehrschichtigen Folie nach Anspruch 14, weiter umfassend den Schritt des Bildens einer Beschichtungsschicht auf wenigstens einer Seite der Mehrfachschicht.

20. Verfahren zum Herstellen der mehrschichtigen Folie nach Anspruch 14, wobei das einzelne Zielmaterial eines oder mehrere umfasst, die ausgewählt sind aus Si, Al, Sn, Ti, Ni, W, Oxid derselben, Nitrid derselben und Carbid derselben.

## Revendications

1. Film multicouche, comprenant
une couche de substrat, et
une couche multiple pourvue sur au moins un côté de la couche de substrat,
dans lequel la couche de substrat est un film plastique,
dans lequel la couche multiple a une structure multicouche, les sous-couches formées d'un ou de plusieurs matériaux constituant des couches étant sélectionnées parmi Si, Al, Sn, Ti, Ni, W, oxyde de ceux-ci, nitrure de ceux-ci et carbure de ceux-ci étant empilées de façon répétée
dans lequel une différence dans la teneur en chaque élément entre les sous-couches est de 3 % ou moins,
dans laquelle une sous-couche est directement empilée sur une autre sous-couche mise en contact l'une à l'autre, et
dans laquelle la structure multicouche possède une structure, dans laquelle une première sous-couche à un intervalle d'épaisseur de 0,1 nm à 50 nm, une seconde sous-couche étant plus fine que la première sous-couche à un intervalle d'épaisseur de 0,1 nm à 10 nm, la première sous-couche à un intervalle d'épaisseur de 0,1 à 50 nm et la seconde sous-couche étant plus fine que la première sous-couche à un intervalle d'épaisseur de 0,1 nm à 10 nm étant empilées en alternance.

2. Film multicouche selon la revendication 1, dans lequel la composition chimique de chaque sous-couche comprend du silicium (Si) et de l'azote (N) et le taux de composition (Si/N) du silicium (Si) à l'azote (N) appartient à l'intervalle de 1 à 20.

3. Film multicouche selon la revendication 1, dans lequel la composition chimique de chaque sous-couche comprend de l'oxygène (O) et de l'azote (N), et le taux de composition (O/N) de l'oxygène (O) à l'azote (N) appartient à l'intervalle de 0,1 à 30.

4. Film multicouche selon la revendication 1, dans lequel la composition chimique de chaque sous-couche comprend de l'oxygène (O) et du silicium (Si), et le taux de composition (O/Si) de l'oxygène (O) au silicium (Si) appartient à l'intervalle de 0,1 à 2.

5. Film multicouche selon la revendication 1, dans lequel la composition chimique de chaque sous-couche comprend du silicium (Si), de l'azote (N) et de l'oxygène (O), le taux de composition (Si/N) du silicium (Si) à l'azote (N) appartient à l'intervalle de 1 là 20, et le taux de composition (O/N) de l'oxygène (O) à l'azote (N) appartient à l'intervalle de 0,1 à 30.

6. Film multicouche selon la revendication 1, dans lequel la composition chimique de chaque sous-couche comprend du silicium (Si), de l'azote (N) et de l'oxygène (O), le taux de composition (Si/N) du silicium (Si) à l'azote (N) appartient à l'intervalle de 1 à 20, le taux de composition (O/N) de l'oxygène (O) à l'azote (N) appartient à l'intervalle de 0,1 à 30, et le taux de composition (O/Si) de l'oxygène (O) au silicium (Si) appartient à l'intervalle de 0,1 à 2.

7. Film multicouche selon la revendication 1, dans lequel la composition chimique de chaque sous-couche comprend 30 à 50 % de silicium (Si), 10 à 65 % d'oxygène (O), et 1 à 50 % d'azote (N), sur la base d'une teneur totale en éléments constituant chaque sous-couche.

8. Film multicouche selon la revendication 1, dans lequel la composition chimique de chaque sous-couche comprend 30 à 50 % de silicium (Si), 10 à 65 % d'oxygène (O), 1 à 50 % d'azote (N), et plus de 0 à 5 % de carbone (C), sur la base de la teneur totale en éléments constituant chaque sous-couche.

9. Film multicouche selon la revendication 1, dans lequel chaque sous-couche possède un taux de composition ((O₂ + N_{4/3})/Si) d'oxygène (O) et d'azote (N) par rapport au silicium (Si) appartenant à l'intervalle de 0,5 à 1.

10. Film multicouche selon la revendication 1, dans lequel la multicouche a une épaisseur de 10 à 5000 nm.

11. Film multicouche selon la revendication 1, comprenant en outre une couche de revêtement pourvue sur au moins un côté de la couche multiple.

12. Dispositif d'affichage comprenant le film multicouche selon la revendication 1.

13. Dispositif à cellule solaire comprenant le film multicouche selon la revendication 1.

14. Procédé de fabrication du film multicouche selon l'une quelconque des revendications 1 à 11, comprenant la formation des sous-couches par l'utilisation d'un seul matériau cible de sorte à former la couche multiple ayant des sous-couches sur au moins un côté de la couche de substrat, dans lequel la différence dans chaque teneur en éléments entre les sous-couches est de 3 % ou moins, dans lequel la couche de substrat est le film plastique et dans lequel la couche multiple comprend une structure multicouches, dans laquelle une première sous-couche à un intervalle d'épaisseur de 0,1 nm à 50 nm, une seconde sous-couche étant plus fine que la première sous-couche à un intervalle d'épaisseur de 0,1 nm à 10 nm, la première sous-couche à l'intervalle d'épaisseur de 0,1 à 50 nm et la seconde sous-couche étant plus fine que la première sous-couche à l'intervalle d'épaisseur de 0,1 nm à 10 nm sont empilées en alternance.

15. Procédé de fabrication du film multicouche selon la revendication 14, dans lequel les sous-couches sont déposées en utilisant du nitrure de silicium (Si₃N₄) en tant que seul matériau cible sous un gaz réactif mélangé constitué d'azote et d'oxygène.

16. Procédé de fabrication du film multicouche selon la revendication 15, dans lequel le gaz réactif mélangé constitué d'azote et d'oxygène est utilisé à un taux de plus de 0 et de 60 % ou moins, sur la base du gaz d'exploitation total.

17. Procédé de fabrication du film multicouche selon la revendication 15, dans lequel le taux d'oxygène et d'azote contenu dans le gaz réactif mélangé constitué d'azote et d'oxygène est de 1 :100 à 80: 30.

18. Procédé de fabrication du film multicouche selon la revendication 14, dans lequel l'étape de formation de sous-couches est réalisée sous une pression de 0,5 à 20 mTorr.

19. Procédé de fabrication du film multicouche selon la revendication 14, comprenant en outre l'étape de formation d'une couche de revêtement sur au moins un côté de la multicouche.

20. Procédé de fabrication d'un film multicouche selon la revendication 14, dans laquelle le seul matériau cible comprend un ou plusieurs éléments sélectionnés parmi Si, Al, Sn, Ti, Ni, W, oxyde de ceux-ci, nitrure de ceux-ci et carbure de ceux-ci.
